# EUROPÄISCHE PATENTANMELDUNG

(11) **EP 1 422 313 A1**
(43) Veröffentlichungstag der Anmeldung: **26.05.2004**
(21) Anmeldenummer: 02024901.7
(22) Anmeldetag: 05.11.2002
(51) Int. Cl.: C23C 14/28, C23C 14/24

(54) **Vorrichtung und Verfahren zum Aufdampfen eines Beschichtungsmaterials im Vakuum mit kontinuierlicher Materialnachführung**

(71) Anmelder: Theva Dünnschichttechnik GmbH, 85737 Ismaning (DE)
(72) Erfinder: Kinder, Helmut Dr.Prof., 85354 Freising (DE)
(74) Vertreter: Hess, Peter K., Dipl.-Phys.

(57) **Zusammenfassung**

Gemäß eines ersten Aspekts betrifft die vorliegende Erfindung eine Vorrichtung zum Aufdampfen eines Beschichtungsmaterials (13) auf ein Substrat (7) im Vakuum (6) mit einer Nachfülleinrichtung (5) zur Aufnahme eines Vorrats an Beschichtungsmaterial (13), einer Verdampfungseinrichtung (1), die das Beschichtungsmaterial (13) in einer Verdampfungszone mit einem Strahl (2) eines energieübertragenden Mediums verdampft und einer Fördereinrichtung (3), die kontinuierlich das Beschichtungsmaterial (13) von der Nachfülleinrichtung (5) zu der Verdampfungszone in einer Weise fördert, dass das zur Verdampfungszone zugeführte Beschichtungsmaterial (13) im wesentlichen rückstandsfrei verdampft wird.

Gemäß eines zweiten Aspekts betrifft die vorliegende Erfindung ein Verfahren zum Aufdampfen einer Beschichtung auf ein Substrat (7) im Vakuum (6) aufweisend die Schritte des kontinuierlichen Zuführens eines Granulats (13) eines Beschichtungsmaterials in eine Verdampfungszone und des Betreibens eines Strahls (2) eines energieübertragenden Mediums, so dass das zugeführte Granulat (13) in der Verdampfungszone im wesentlichen rückstandsfrei verdampft wird.

## Beschreibung

### 1. Technisches Gebiet

Die vorliegende Erfindung betrifft eine Vorrichtung und ein Verfahren zum Aufdampfen eines Beschichtungsmaterials im Vakuum, insbesondere zur Herstellung von Beschichtungen aus komplexen anorganischen Verbindungen wie Hochtemperatursupraleitern.

### 2. Der Stand der Technik

Dünne Schichten aus komplexen anorganische Verbindungen, z.B. aus Oxiden, Nitriden, Carbiden oder Legierungen verschiedener Kationen, dienen in vielen Anwendungen der Elektronik, Optik oder des Maschinenbaus als Funktionsschichten oder Oberflächenvergütungen. So werden zum Beispiel Schichten aus PZT (Blei-Zirkonat-Titanat) - Keramiken oder BaTiO₃ für ferroelektrische Sensorelemente oder als Datenspeicher mit hoher Dielektrizitätskonstante eingesetzt. Dünne epitaktische Schichten aus RBa₂Cu₃O₇ (R = Yttrium oder ein Element der seltenen Erden) werden bei tiefen Temperaturen supraleitend und können z.B. in der Kommunikationstechnik für trennscharfe Hochfrequenzfilter oder aufgebracht auf flexiblen Metallbändern als verlustlose Stromleiter eingesetzt werden.

Für den wirtschaftlichen Einsatz müssen für viele dieser Anwendungen große Flächen oder große Längen (Bandleiter) in möglichst kurzer Zeit beschichtet werden. Da viele Verbindungen die gewünschten Eigenschaften nur bei hoher kristalliner Perfektion der Schicht zeigen, werden an die Beschichtungstechnik hohe Anforderungen gestellt. Bei Mischverbindungen muss zudem die korrekte stoichiometrische Zusammensetzung über die gesamte Beschichtungsfläche und die gesamte Dauer der Beschichtung gewährleistet sein.

In der Regel werden zur Beschichtung Vakuumbeschichtungsverfahren wie Sputtern, Laserablation (PLD), chemische Gasphasenabscheidung (CVD), Molekularstrahlepitaxie (MBE) oder Verdampfen angewandt. Für Techniken, die von keramischen, nichtleitende Verbindungen (Targets) ausgehen, (z.B. Sputtern, PLD) ist die Volumenabscheiderate meist sehr gering. Techniken wie CVD oder Ko-verdampfen, wie zum Beispiel in EP 0 282 839 B1 beschrieben, benutzen einzelne Materialquellen, deren Materialflüsse individuell mit Hilfe einer komplexen Regelung gesteuert werden müssen. Da die Materialien zudem nicht aus einer Punktquelle stammen bzw. empfindlich auf lokale physikalische Abscheideparameter wie Substrattemperatur oder Gasdruck reagieren, kommt es auf großen Flächen trotzdem zu Schwankungen in der Zusammensetzung der Schicht.

Das ideale Beschichtungsverfahren würde mit einer Punktquelle arbeiten, aus der das Material in der richtigen Zusammensetzung mit hohem Materialfluss austritt und sich homogen auch über größere Entfernungen ausbreitet und auf großer Fläche abscheidet. Dieses Ideal ist mit dem Elektronenstrahlverdampfen, bei dem ein hochenergetischer Elektronenstrahl das Zielmaterial extrem erhitzt und zum Verdampfen bringt, in guter Näherung erfüllt. Dieses Verfahren wird deshalb in vielen technischen Beschichtungsprozessen für einfache Verbindungen oder Elemente wie z.B. für Aluminium für Reflektoren oder Verpackungsfolien oder einfache Oxide für optische Oberflächenvergütungen eingesetzt. Problematisch ist jedoch das Verdampfen von Materialmischungen mit stark unterschiedlichen Dampfdrücken der Einzelkomponenten oder Verbindungen, die bei Elektronenbeschuss chemisch zerstört werden (cracken) oder fraktionieren.

In JP 0 12 64 114 A ist ein solches Verfahren für die Abscheidung von Hochtemperatur - Supraleiterfilmen beschrieben. Die damit erreichten Ergebnisse sind jedoch mangelhaft. Werden nämlich derartige Mischungen oder Verbindungen aus einem einzelnen Tiegel verdampft, so tritt Fraktionierung auf und auf Grund der ständig wechselnden lokalen thermischen Verhältnisse ändert sich im zeitlichen Verlauf die Zusammensetzung der abgedampften Materialien. Diesem Problem kann man durch schnelle Ablenkung des Elektronenstrahls in mehrere, voneinander unabhängige Tiegel, und die jeweilige Verweildauer des Elektronenstrahls begegnen. Allerdings nimmt man damit wieder die Nachteile in Kauf, die durch Verwendung mehrerer lokal getrennter Einzelquellen entstehen, nämlich Gradienten der Zusammensetzung auf größeren Flächen.

Alternativ wurde deshalb zur Herstellung von Legierungsbeschichtungen in der JP 6 11 95 968 A ein Verfahren beschrieben, bei dem die Legierungsbestandteile in verschieden großen, sektorförmigen Taschen einer rotierbaren Verdampferquelle eingebracht werden. Durch schnelles Rotieren unter einem feststehenden Elektronenstrahl kann auch auf diese Weise im zeitlichen Mittel die gewünschte Zusammensetzung aus einem Punkt verdampft werden. Problematisch bei dieser Anordnung ist jedoch, dass die Kapazität der Tiegel begrenzt ist und eine kontinuierliche Nachfüllung auf Grund der Rotation nicht in Frage kommt. Das Verfahren eignet sich deshalb nicht für eine kontinuierliche Langzeitbeschichtung, bei der große Materialmengen benötigt werden. Dasselbe gilt für ähnliche Vorrichtungen mit rotierbaren Elektronenstrahl-Verdampferquellen wie der in JP 20 02 097 566 A beschriebenen, die das selektive Verdampfen verschiedener Materialien ermöglichen oder der in JP 02 294 479 A beschriebenen Anordnung, die das "Eingraben" des Elektronenstrahls verhindert und eine gleichbleibende frische Oberfläche des Verdampfungsguts garantiert.

Für die kontinuierliche Produktion kommt dem Materialnachschub entscheidende Bedeutung zu. Für statische Verdampfertiegel sind derartige Nachfülleinrichtungen z.B. aus JP 61 003 880 A bekannt. Das Verdampfen aus einem statischen Tiegel oder das allmähliche Verdampfen selbst aus einem sich bewegenden Tiegel führt bei komplexen Verbindungen, wie z.B. oxidischen Hochtemperatur - Supraleitern, auf Grund von Fraktionierung zu Problemen mit der chemischen Zusammensetzung der Beschichtung. Die Ursache liegt darin, dass im Verdampfertiegel kein Gleichgewicht erreicht wird, da sich lokal die thermischen und chemischen Verhältnisse ständig ändern.

Ein Ausweg ist das sogenannte "Flashverdampfen" einzelner Materialkörner. Dadurch werden nacheinander jeweils kleine Portionen (Körner) des zu verdampfenden Materials quantitativ, d. h. im wesentlichen ohne Rückstand, verdampft. Dadurch wird erzwungen, dass der Dampf im zeitlichen Mittel über einige Körner dieselbe Zusammensetzung wie das Verdampfungsmaterial aufweist. Allgemeiner gesprochen kommt es beim quantitativen Verdampfen aber gar nicht so sehr darauf an, dass eine Materialportion quasi instantan verdampft wird, sondern vorwiegend darauf, dass sich in der Verdampfungszone ein Gleichgewicht zwischen dem Verdampfen durch den Elektronenstrahl und der ständigen Materialzufuhr einstellt.

Ein erster Ansatz für diese Art der Verdampfung wurde von Davis et al. im J. Appl. Phys. 66, (1989) 4903, beschrieben. Die Autoren versuchten, oxidische Supraleiterschichten herzustellen, indem sie eine dünne Linie (Spur) aus Pulver des jeweiligen Aufdampfmaterials mit dem Elektronenstrahl von vorne nach hinten abtrugen. An der heißen Front sollten ständig einzelne Pulverkörner in Sekundenbruchteilen verdampft werden. Die Resultate dieser Versuche waren jedoch unbefriedigend. Da das pulverisierte Ausgangsmaterial eine große innere Oberfläche aufweist und z.T. sogar hygroskopisch ist, befindet sich sehr viel adsorbiertes Wasser an den Körnern. Beim starken Aufheizen verdampft dieses schlagartig und sprengt die Pulverkörner auseinander, so dass sie aus der Verdampfungszone geschleudert statt in die Gasphase überführt werden. Aus diesem Grund wurde ein Zweistufenverfahren angewandt. In einem ersten Schritt wurde das Pulver durch den erheblich schwächer eingestellten Elektronenstrahl entgast und das Pulver zu kleinen Tröpfchen aufgeschmolzen. Im zweiten Schritt wurde versucht, diese Tröpfchen durch Flashverdampfen in die Gasphase zu überführen.

Auf Grund dieser Prozessführung ist unmittelbar klar, dass das Verfahren nicht für größere Materialmengen oder gar kontinuierlichen Betrieb in Frage kommt. Zudem verschiebt sich der Verdampfungspunkt laufend entlang der Spur. Darüber hinaus stellte sich jedoch heraus, dass die Tröpfchen mit ca. 0,1 g Gewicht bereits zu groß waren, um instantan in die Gasphase überführt zu werden. Konzentrationstiefenprofile der durch das Verdampfen eines Tröpfchens hergestellten Schicht - in diesem Fall YBa₂Cu₃O₇ - zeigen ausgeprägte Fraktionierung mit einer starken Ba - Anreicherung an der Filmoberfläche. Die Filme müssen deshalb thermisch nachbehandelt werden und sind selbst danach von schlechter Qualität.

Der vorliegenden Erfindung liegt daher das Problem zugrunde, eine Vorrichtung und ein Verfahren zum Aufdampfen eines Beschichtungsmaterials auf einem Substrat bereitzustellen, das einerseits mit hohen Raten wirtschaftlich betrieben werden kann und andererseits zu Schichten guter Qualität führt und damit die erläuterten Nachteile des Stands der Technik überwindet.

### 3. Zusammenfassung der Erfindung

Gemäß eines ersten Aspekts betrifft die vorliegende Erfindung eine Vorrichtung zum Aufdampfen eines Beschichtungsmaterials auf ein Substrat im Vakuum, insbesondere zur Herstellung von Beschichtungen aus komplexen anorganischen Verbindungen wie Hochtemperatursupraleitern, mit einer Nachfülleinrichtung zur Aufnahme eines Vorrats an Beschichtungsmaterial, einer Verdampfungseinrichtung, die das Beschichtungsmaterial in einer Verdampfungszone mit einem Strahl eines energieübertragenden Mediums verdampft und einer Fördereinrichtung, die kontinuierlich das Beschichtungsmaterial von der Nachfülleinrichtung zu der Verdampfungszone in einer Weise fördert, dass das zur Verdampfungszone zugeführte Beschichtungsmaterial im wesentlichen rückstandsfrei verdampft wird.

Mit der erfindungsgemäßen Vorrichtung stellt sich in der Verdampfungszone ein Gleichgewicht zwischen dem kontinuierlichen Materialabtrag durch den Strahl des energieübertragenden Mediums und der kontinuierlichen Materialzufuhr durch die Fördereinrichtung ein. Da die im wesentlichen rückstandsfreie Verdampfung mit konstanter Rate (einstellbar über die Materialzufuhr) im wesentlichen im Gleichgewicht und aus einer im wesentlichen stationären Punktquelle erfolgt, wird keine komplizierte Ratenregelung benötigt und die Zusammensetzung des abgeschiedenen Films ist über die gesamte Beschichtungsfläche homogener als mit bisher bekannten Beschichtungstechniken. Zudem kann das Substrat in der erfindungsgemäßen Vorrichtung sehr nahe an die Verdampfungszone herangebracht werden und einen großen Raumwinkel abdecken, um die Ausbeute des verdampften Materials zu erhöhen. Dies ist als großer Vorteil gegenüber einer Anordnung mit mehreren Quellen (Koverdampfen, MBE) zu sehen, bei der immer ein gewisser Mindestabstand eingehalten werden muss, um Abweichungen der Zusammensetzung in Grenzen zu halten.

Bevorzugt wird der Strahl der Verdampfungseinrichtung in zumindest einer Richtung über die Verdampfungszone gescannt, wobei das von der Fördereinrichtung zur Verdampfungszone geförderte Beschichtungsmaterial vorzugsweise zunächst vorerhitzt und dann verdampft wird.

In einer ersten bevorzugten Ausführungsform umfasst die Verdampfungseinrichtung einen vorzugsweise modulierbaren Elektronenstrahlverdampfer. Denkbar sind jedoch auch Einrichtungen zur Erzeugung anderer hochenergetischer Partikelstrahlen (z.B. Ionenbeschuss) oder die Verwendung eines Lasers. Elektronenstrahlen sind gegenwärtig bevorzugt, da sie vergleichsweise kostengünstig sind und sich gut modulieren lassen.

Bevorzugt wird das Beschichtungsmaterial linienförmig in die Verdampfungszone gefördert, wobei die Linienform vorzugsweise eine Breite zwischen 3 und 30 mm aufweist. Das Beschichtungsmaterial wird dabei vorzugsweise als ein Granulat mit einer Korngröße von vorzugsweise 0,1 - 0,5 mm zu der Verdampfungszone gefördert.

Granulares Schüttgut lässt sich besonderes einfach nachfüllen. Die angegebenen Parameter stellen dabei sicher, dass die Wärmekapazität der einzelnen Körner des Beschichtungsmaterials nicht zu groß ist, und sie hinreichend schnell verdampfen. Ähnliches gilt auch wenn die Körner nicht einzeln "flashverdampft" werden, sondern über eine etwas längere Strecke x, d.h. über längere Zeit hinweg verdampft werden. Die feine Körnung ist in diesem Fall wichtig für eine ausreichende Statistik, da das Material im Einzelkorn durchaus fraktionieren kann.

Die Fördereinrichtung umfasst vorzugsweise einen drehbaren Tisch und / oder eine rotierende Walze und / oder ein Vibrationsförderer und / oder ein Förderband und / oder eine Förderschnecke oder -rutsche. Mit diesen Einrichtungen, die nur beispielhaft genannt sind, lassen sich durch entsprechend hohe Rotations- bzw. Fördergeschwindigkeiten und eine entsprechende Leistung der Verdampfereinrichtung sehr hohe Verdampfungsraten im Dauerbetrieb erzielen. Die Nachfülleinrichtung ist bevorzugt als ein Trichter ausgebildet.

Vorzugsweise wird die Fördereinrichtung gekühlt, um eine Zerstörung durch den Elektronenstrahl zu verhindern. Die Nachfülleinrichtung hingegen ist vorzugsweise geheizt und weist bevorzugt eine separate Pumpeinrichtung auf. In einem besonders bevorzugten Ausführungsbeispiel ist die Nachfülleinrichtung als ein im unteren Bereich heizbarer Trichter ausgebildet und die separate Pumpeinrichtung als ein Saugrüssel, der in den unteren Bereich hineinragt. Das bevorzugt granulare Beschichtungsmaterial, insbesondere wenn es sich um ein hygroskopisches Material handelt, kann Wasser aufnehmen, was beim Elektronenbeschuss zur Explosion der Körner und damit zum Verlust des Materials aus der Verdampfungszone führt. Mit den erläuterten bevorzugten Merkmalen der Vorrichtung wird dies verhindert und darüber hinaus sichergestellt, dass das Kammervakuum nicht beeinträchtigt wird. Alternativ kann das Granulat auch thermisch vorbehandelt und entgast werden und interner versiegelten Kartusche an die Fördereinrichtung angeflanscht werden.

Vorzugsweise weist das Beschichtungsmaterial zumindest eine Verbindung auf. Die Vorrichtung umfasst bevorzugt Mittel, die zumindest eine Komponente der Verbindung dem Beschichtungsmaterial vor dem Verdampfen hinzuzumischen. Dadurch kann die mittlere Zusammensetzung des zu verdampfenden Beschichtungsmaterials flexibel variiert werden, beispielsweise um eine Beeinflussung der Stoichiometrie durch unterschiedliche Haftkoeffizienten auf dem Substrat zu kompensieren. Die Mischvorrichtung kann innerhalb oder außerhalb des Vakuums angeordnet werden, oder das Material wird vorgemischt aus verschiedenen Komponenten.

Gemäß einer weiteren bevorzugen Ausführungsform weist das Beschichtungsmaterial ein Gemisch unterschiedlicher Verbindungen auf, so dass beim Verdampfen im zeitlichen Mittel die gewünschte Zusammensetzung des Beschichtungsmaterials abgeschieden wird, um statistische Schwankungen in der Filmzusammensetzung zu vermeiden. Ferner umfasst die Vorrichtung vorzugsweise Mittel, die ermöglichen, in der Nähe des Substrats ein Gas abzugeben, so wie in der DE 19 680 845 C1 beschrieben. Dadurch können gasförmige Bestandteile des Beschichtungsmaterials, die beim Verdampfen verloren gehen; kompensiert werden.

Gemäß eines zweiten Aspekts betrifft die vorliegende Erfindung ein Verfahren zum Aufdampfen einer Beschichtung auf ein Substrat im Vakuum, insbesondere aus zumindest einer anorganischen Verbindung mit mindestens zwei unterschiedlichen Kationenkomponenten, aufweisend die Schritte des kontinuierlichen Zuführens eines Granulats eines Beschichtungsmaterials in eine Verdampfungszone und des Betreibens eines Strahls eines energieübertragenden Mediums, so dass das zugeführte Granulat in der Verdampfungszone im wesentlichen rückstandsfrei verdampft wird.

Vorzugsweise wird das Granulat der Verdampfungszone in Form einer Linie zugeführt, wobei der Strahl des energieübertragenden Mediums über ein Ende der Linie geführt wird, so dass die Linie im wesentlichen in ihrer ganzen Breite und über einen kleinen:Bereich in Zuführrichtung gerastert wird.

Bevorzugt ist das Beschichtungsmaterial ein oxidischer Hochtemperatursupraleiter, insbesondere RBa₂Cu₃O₇ (R = Yttrium oder ein Element der Ordnungszahl 57 bis 71 oder eine Mischung dieser Elemente).

Weitere Fortentwicklungen der erfindungsgemäßen Vorrichtung und des erfindungsgemäßen Verfahrens bilden den Gegenstand weiterer abhängiger Patentansprüche.

### 4. Kurze Beschreibung der Zeichnungen

Im folgenden werden bevorzugte Ausführungsbeispiele der Erfindung im Detail beschrieben mit Bezug auf die folgenden Figuren, die zeigen:
- Fig. 1:: Schemaskizze einer bevorzugten Ausführungsform der erfindungsgemäßen Vorrichtung in Aufsicht;
- Fig. 2:: Schematischer Querschnitt einer bevorzugten Ausführungsform der erfindungsgemäßen Vorrichtung mit Trichternachfülleinrichtung;
- Fig. 3:: Schematischer Querschnitt einer bevorzugten Ausführungsform der erfindungsgemäßen Vorrichtung mit Elektronenstrahlverdampfer, Materialnachfüllung und Substrathalter;

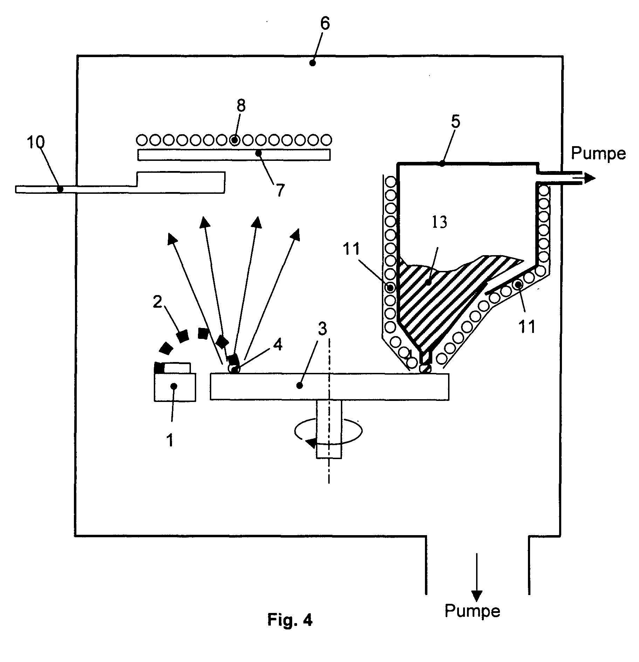

- Fig. 4:: Schematischer Querschnitt einer bevorzugten Ausführungsform der erfindungsgemäßen Vorrichtung mit Elektronenstrahlverdampfer, Substrathalter und beheizbarem, abgepumptem Materialvorratsbehälter;

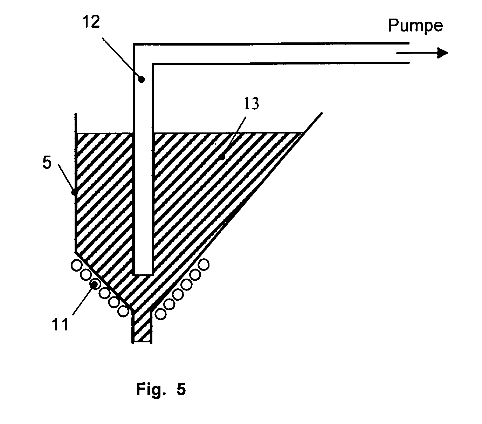

- Fig. 5:: Detaildarstellung eines beheizbaren Nachfülltrichters mit Absaugrohr;
- Fig. 6a:: Verdampfungszone der Vorrichtung (gestrichelt) am Ende der Materialspur. Die Transportrichtung ist durch den Pfeil gekennzeichnet.
- Fig. 6b:: Leistungsprofil des Elektronenstrahls in Transportrichtung x;
- Fig. 6c:: Mittlere Dicke bzw. Menge D der Materialspur beim Einlauf in die Verdampfungszone.

### 5. Detaillierte Beschreibung der Erfindung

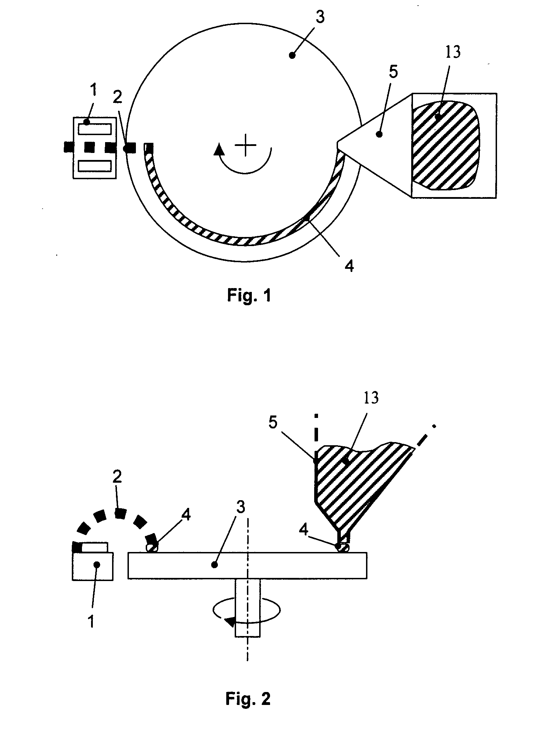

In dem in Fig. 1 gezeigten bevorzugten Ausführungsbeispiel einer erfindungsgemäßen Vorrichtung wird eine einige Millimeter bis einige Zentimeter breite Spur 4 kleingranularen Materials 13 auf eine Fördereinrichtung in Form eines gekühlten, rotierenden Tischs 3 aus gut wärmeleitendem Material, vorzugsweise Kupfer, aufgebracht und einem Elektronenstrahlverdampfer 1 zugeführt. Dazu wird das Material 13 von einem großen Reservoir durch eine kontinuierlich arbeitende Nachfülleinrichtung 5 dosiert auf der Fördereinrichtung 3 als Linie oder Spur 4 von einigen Millimetern bis einigen Zentimetern Breite aufgebracht.

Die Fördereinrichtung 3 zieht diese Linie 4 aus der Nachfülleinrichtung 5 heraus bis in die heiße Verdampfungszone eines Elektronenstrahls 2 hinein. Durch diesen wird die Linie 4 dann kontinuierlich und im wesentlichen rückstandsfrei verdampft. Der Strahl 2 kann dazu über die Linienbreite gerastert werden oder ist entsprechend breit. Durch die Rotations- bzw. Fördergeschwindigkeit der Fördereinrichtung 3 sowie den Querschnitt der Linie 4 lässt sich die Verdampfungsrate regeln. Durch entsprechend hohe Fördergeschwindigkeit und Leistung des Elektronenstrahls 2 lassen sich insbesondere auch sehr hohe Verdampfungsraten im Dauerbetrieb erzielen.

Quantitatives, d.h. im wesentlichen rückstandsfreies Verdampfen lässt sich dadurch erzielen, dass sich in einer räumlich eng begrenzten Verdampfungszone von einigen Millimetern Länge ein Gleichgewicht zwischen dem kontinuierlichen Materialabtrag durch den Elektronenstrahl 2 und der Materialzufuhr einstellt. Der Elektronenstrahl 2 kann dazu wie in Fig. 6a dargestellt, über eine Fläche (gestrichelt), die die Spitze des ankommenden Materialstroms 4 vollständig überdeckt, gerastert und auch in der Intensität moduliert werden. Moderne Elektronenstrahlverdampfer verfügen über diese Möglichkeiten.

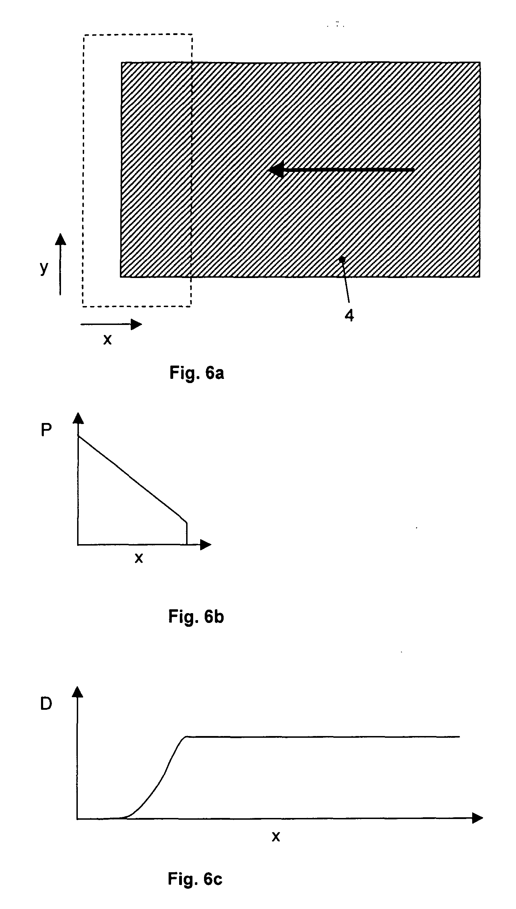

Vorzugsweise wird die Leistung des Elektronenstrahls 2 so moduliert (vgl. z.B. Fig. 6b) , dass neu ankommendes Material zunächst mit schwächerer Leistung vorerhitzt wird und mit fortschreitendem Transport in die heiße Verdampfungszone hinein zunächst aufgeschmolzen und dann im wesentlichen vollständig verdampft wird. Am anderen Ende der Verdampfungszone sollte die Leistung P des Elektronenstrahl 2 so hoch sein, dass im wesentlichen keine Rückstände auf der Fördereinrichtung 3 zurückbleiben.

Fig. 6c zeigt den räumlichen Verlauf der mittleren Dicke D der Materialspur 4 bzw. der mittleren Materialmenge in der Spur 4. Selbst wenn bei dieser Anordnung die unterschiedlichen Komponenten des Aufdampfmaterials aus unterschiedlichen Bereichen der heißen Verdampfungszone stammen, so stellt sich jedoch im kontinuierlichen Betrieb nach einer kurzen Anfangsphase ein Gleichgewicht ein, so dass im Mittel immer die durch das Aufdampfmaterial vorgegebene Zusammensetzung verdampft wird. Da die durch den Elektronenstrahl überstrichene Fläche in Richtung der ankommenden Materialspur x nur eine Ausdehnung von einigen Millimetern hat, ist das Ideal einer Punktquelle in guter Näherung erfüllt.

Zur Erzielung hoher Verdampfungsraten hat es sich als vorteilhaft erwiesen, die Materiallinie 4 bis zu einige Zentimeter breit (y - Richtung) und sehr dünn aufzubringen. Dies vermeidet beim Anschmelzen des Materials im Eintrittsbereich der heißen Verdampfungszone die Bildung zu großer Tröpfchen, so dass statistische Schwankungen klein bleiben.

Mit der Vorrichtung und dem Verfahren gemäß von Ausführungsbeispielen der vorliegenden Erfindung wurden oxidischen Hochtemperatur - Supraleiterschichten des Materials YBa₂Cu₃O₇ (YBCO) hergestellt. Als Hochtemperatur - Supraleiter kommt jedoch auch allgemein RBa₂Cu₃O₇ (R = Yttrium oder ein Element der Ordnungszahl 57 bis 71 oder eine Mischung dieser Elemente) in Betracht. Granulares Material mit leichtem Kupferüberschuss und mit 0,1 mm Korngröße wurde über einen Trichter 5 in Form einer 3 - 30 mm breiten und 0,1 - 1 mm hohen Spur 4 auf einem Kupferteller 3 aufgebracht und durch kontinuierliche Rotation von unten aus dem Trichter 5 herausgezogen und dem Elektronenstrahl 2 zugeführt. Sauerstoff wurde am ca. 680°C heißen Substrat 7 gezielt zugeführt, das zur Vermeidung von Schichtdickenvariationen bewegt werden kann, so dass ein epitaktischer Supraleiterfilm mit einer Abscheiderate von 0,4 nm/s deponiert wurde. Durch Anpassung der Rotationsgeschwindigkeit des Tellers 3 und der Leistung des Elektronenstrahlverdampfers 2 konnten jedoch auch ohne Probleme Bedampfungsraten von über 2 nm/s realisiert werden. Die auf MgO - Einkristallen hergestellten Supraleiterfilme zeigen Sprungtemperaturen von 87 K und kritische Stromdichten von über 2 MA/cm², was als ausgezeichnete Qualität für Anwendungen gilt.

Zur erläuternden Darstellung von Abwandlungen der erfindungsgemäßen Vorrichtung und des erfindungsgemäßen Verfahrens werden im Folgenden gegenwärtig besonders bevorzugte Beispiele 1 - 8 näher erläutert:

### Beispiel 1:

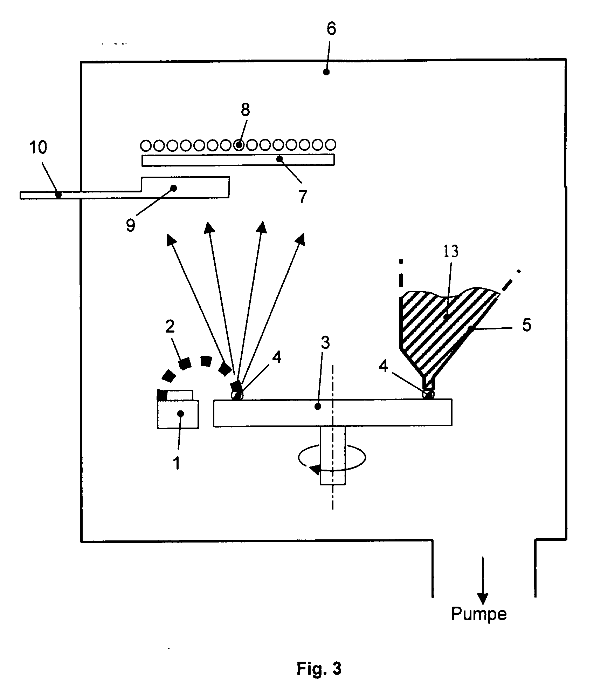

Granulares Aufdampfmaterial 13 wird über einen trapezförmig zulaufenden Trichter 5 auf den rotierbaren, wassergekühlten Kupferteller 3 eines Elektronenstrahlverdampfers 1 geleitet. Durch Rotation des Tellers 3 wird eine feine Linie des Materials 4 von unten aus dem Trichter 5 gezogen und dem Elektronenstrahl 2 auf der gegenüber liegenden Seite zugeführt. Die Leistung und Fokussierung des Elektronenstrahls 2 ist derart eingestellt, dass die ankommenden Körner des Aufdampfmaterials bei Eintritt in die heiße Verdampfungszone schnell und im wesentlichen rückstandsfrei, d.h. quantitativ verdampfen. Der Dampf breitet sich in der Hochvakuumkammer 6 ungehindert aus und schlägt sich auf einem nötigenfalls beheizten (vgl. Substratheizung 8 in Fig. 3) Substrat 7 nieder. Bei Bedarf kann auch Reaktivgas in die Kammer 6 eingelassen oder durch entsprechende Vorrichtungen 9, 10 direkt am Substrat 7 zugeführt werden.

### Beispiel 2:

Die Anordnung entspricht der in Beispiel 1 beschriebenen. Das Granulat 13 stammt jedoch aus einem geschlossenen, über Heizelemente 11 beheizbaren Vorratsgefäß 5, das über einen Pumpstutzen abgepumpt werden kann, um frei werdende Restgase zu entfernen.

### Beispiel 3:

Die Anordnung entspricht der in Beispiel 1 beschriebenen. Das Granulat 13 wird jedoch über einen Trichter 5 zugeführt, der nur im unteren Auslassbereich durch Heizelemente 11 beheizt wird. Der dabei frei werdende Wasserdampf wird direkt am Entstehungsort über ein Saugrohr 12 , vorteilhaft mit einem Siebvorsatz am Einlass (nicht dargestellt), abgepumpt.

### Beispiel 4:

Granulares Aufdampfmaterial 13 wird über ein Förderband, eine Förderschnecke oder eine ähnliche Fördereinrichtung wie über eine Rutsche (nicht dargestellt) auf den rotierbaren, wassergekühlten Kupferteller 3 eines Elektronenstrahlverdampfers geleitet. Durch die Rotation des Tellers 3 wird eine feine Linie des Materials 4 dem Elektronenstrahl 2 auf der gegenüberliegenden Seite zugeführt. Die Leistung und Ausdehnung des Elektronenstrahls 2 ist derart eingestellt, dass die ankommenden Körner des Aufdampfmaterials 13 bei Eintritt in die heiße Zone schnell und im wesentlichen rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer eingelassen oder durch entsprechende Vorrichtungen 9, 10 direkt am Substrat 7 zugeführt werden.

### Beispiel 5:

Granulares Aufdampfmaterial 13 wird über eine Nachfülleinrichtung, z.B. einen trapezförmig zulaufenden Trichter 5, auf eine rotierende, wassergekühlten Walze (nicht dargestellt) aufgebracht und als feine Linie dem Elektronenstrahl 2 eines Elektronenstrahlverdampfers zugeführt. Die Leistung und Fokussierung des Elektronenstrahls ist derart eingestellt, dass die ankommenden Körner des Aufdampfmaterials bei Eintritt in die heiße Zone schnell und im wesentlichen rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer eingelassen oder durch entsprechende Vorrichtungen 9, 10 direkt am Substrat 7 zugeführt werden.

### Beispiel 6:

Granulares Aufdampfmaterial 13 wird über eine Nachfülleinrichtung, z.B. einen trapezförmig zulaufenden Trichter 5, auf einen wassergekühlten Vibrationsförderer aufgebracht und als feine Linie dem Elektronenstrahl 2 eines Elektronenstrahlverdampfers 1 zugeführt. Die Leistung und Fokussierung des Elektronenstrahls ist derart eingestellt, dass die ankommenden Körner des Aufdampfmaterials bei Eintritt in die heiße Zone schnell und rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer 6 eingelassen oder durch entsprechende Vorrichtungen 9, 10 direkt am Substrat 7 zugeführt werden.

### Beispiel 7:

Granulares Aufdampfmaterial 13 wird über eine Nachfülleinrichtung, z.B. einen trapezförmig zulaufenden Trichter 5, auf ein gekühltes Förderband aufgebracht und als feine Linie dem Elektronenstrahl 2 eines Elektronenstrahlverdampfers zugeführt. Die Leistung und Fokussierung des Elektronenstrahls ist derart eingestellt, dass die ankommenden Körner des Aufdampfmaterials bei Eintritt in die heiße Zone schnell und rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer eingelassen oder durch entsprechende Vorrichtungen 9, 10 direkt am Substrat 7 zugeführt werden.

### Beispiel 8:

Materialzufuhr und Transport entsprechen einem der vorangegangenen Beispiele 1- 7. Die Materialspur 4 kann eine Breite von mehreren Zentimetern aufweisen. Der Elektronenstrahl 2 wird über eine Fläche, die die Breite der ankommenden Materialspur 4 vollständig überdeckt, z.B. eine rechteckige Fläche wie in Fig. 6a dargestellt, gerastert. Dabei wird die Leistung P des Elektronenstrahls 2 so moduliert, dass das ankommende Material mit fortschreitender Position zunächst vorerhitzt, angeschmolzen und dann vollständig verdampft wird. Ein geeignetes Leistungsprofil ist beispielsweise in Fig. 6b dargestellt. Die Form des Profils (z.B. linear, exponentiell, sinusförmig, etc.) kann dabei geeignet gewählt werden. Wichtig ist in diesem Zusammenhang hauptsächlich, dass die Spitzenleistung hoch genug gesetzt wird, so dass das gesamte Material im wesentlichen rückstandsfrei verdampft. In diesem Fall kann sich z.B. ein Dickenprofil der Materialspur wie in Fig. 6c gezeigt einstellen.

### Bezugszeichenliste:

- 1: Elektronenkanone
- 2: Elektronenstrahl
- 3: Teller (drehbar)
- 4: Materialspur (Linie)
- 5: Nachfülleinrichtung, (Trichter, Vorratsgefäß)
- 6: Vakuumkammer
- 7: Substrat
- 8: Substratheizung
- 9: Reaktionsgasversorgung
- 10: Gaseinlass
- 11: Heizelement
- 12: Saugrohr
- 13: Granulat

## Patentansprüche

1. Vorrichtung zum Aufdampfen eines Beschichtungsmaterials (13) auf ein Substrat (7) im Vakuum (6), insbesondere zur Herstellung von Beschichtungen aus zumindest einer anorganischen Verbindung mit mindestens zwei unterschiedlichen Kationenkomponenten wie Hochtemperatursupraleitern, aufweisend:
a. eine Nachfülleinrichtung (5) zur Aufnahme eines Vorrats an Beschichtungsmaterial (13);
b. eine Verdampfungseinrichtung(1), die das Beschichtungsmaterial (13) in einer Verdampfungszone mit einem Strahl (2) eines energieübertragenden Mediums verdampft;
c. eine Fördereinrichtung (3), die kontinuierlich das Beschichtungsmaterial (13) von der Nachfülleinrichtung (5) zu der Verdampfungszone in einer Weise fördert, dass
d. das zur Verdampfungszone zugeführte Beschichtungsmaterial (13) im wesentlichen rückstandsfrei verdampft wird.

2. Vorrichtung nach Anspruch 1, wobei der Strahl (2) der Verdampfungseinrichtung (1) in zumindest einer Richtung über die Verdampfurigszone gescannt werden kann.

3. Vorrichtung nach Anspruch 1 oder 2, wobei das von der Fördereinrichtung (3) zur Verdampfungszone geförderte Beschichtungsmaterial (13) zunächst vorerhitzt und dann verdampft wird.

4. Vorrichtung nach einem der Ansprüche 1 - 3, wobei die Verdampfungseinrichtung (1) einen vorzugsweise modulierbaren Elektronenstrahlverdampfer (1) umfasst.

5. Vorrichtung nach Anspruch 4, wobei das Beschichtungsmaterial (13) linienförmig in die Verdampfungszone gefördert wird.

6. Vorrichtung nach Anspruch 5, wobei die Linienform (4) eine Breite zwischen 3 und 30 mm aufweist.

7. Vorrichtung nach einem der Ansprüche 1 - 6, wobei das Beschichtungsmaterial (13) als ein Granulat (13) mit einer Korngröße von vorzugsweise 0,1 - 0,5 mm zu der Verdampfungszone gefördert wird.

8. Vorrichtung nach einem der Ansprüche 1 - 7, wobei die Fördereinrichtung (3) kühlbar ist und einen drehbaren Tisch und / oder eine rotierende Walze und / oder ein Vibrationsförderer und / oder ein Förderband und / oder eine Förderschnecke oder -rutsche umfasst.

9. Vorrichtung nach einem der Ansprüche 1 - 8, wobei die Nachfülleinrichtung als ein Trichter (5) ausgebildet ist.

10. Vorrichtung nach einem der Ansprüche 1 - 9, wobei die Nachfülleinrichtung (5) geheizt ist.

11. Vorrichtung nach Anspruch 10, wobei die Nachfülleinrichtung (5) eine separate Pumpeinrichtung (12) aufweist.

12. Vorrichtung nach Anspruch 11, wobei die Nachfülleinrichtung (5) als ein im unteren Bereich heizbarer Trichter (5) ausgebildet ist und die separate Pumpeinrichtung (12) als ein Saugrüssel (12) ausgebildet ist, der in den unteren Bereich hineinragt.

13. Vorrichtung nach einem der vorhergehenden Ansprüche, wobei das Beschichtungsmaterial (13) ein Gemisch unterschiedlicher Verbindungen aufweist, so dass beim Verdampfen im zeitlichen Mittel die gewünschte Zusammensetzung des Beschichtungsmaterials (13) abgeschieden wird.

14. Vorrichtung nach einem der vorhergehenden Ansprüche, ferner aufweisend Mittel (9, 10), die ermöglichen, in der Nähe des Substrats (7) ein Gas abzugeben.

15. Vorrichtung nach einem der vorhergehenden Ansprüche, ferner aufweisend Mittel, um das Substrat relativ zur Verdampfungszone zu bewegen.

16. Verfahren zum Aufdampfen einer Beschichtung auf ein Substrat (7) im Vakuum (6), insbesondere aus zumindest einer anorganischen Verbindung mit mindestens zwei unterschiedlichen Kationenkomponenten, aufweisend:
a. kontinuierliches Zuführen eines Granulats (13) eines Beschichtungsmaterials in eine Verdampfungszone; und
b. Betreiben eines Strahls (2) eines energieübertragenden Mediums, so dass das zugeführte Granulat (13) in der Verdampfungszone im wesentlichen rückstandsfrei verdampft wird.

17. Verfahren nach Anspruch 16, wobei das Granulat (13) der Verdampfungszone in Form einer Linie (4) zugeführt wird.

18. Verfahren nach Anspruch 17 wobei der Strahl (2) des energieübertragenden Mediums über ein Ende der Linie (4) geführt wird, so dass die Linie (4) im wesentlichen in ihrer ganzen Breite und über einen kleinen Bereich in Zuführrichtung gerastert wird.

19. Verfahren nach Anspruch 18, wobei das Beschichtungsmaterial (13) ein oxidischer Hochtemperatursupraleiter ist.

20. Verfahren nach Anspruch 19, wobei der Hochtemperatursupraleiter RBa₂Cu₃O₇ (R = Yttrium oder ein Element der Ordnungszahl 57 bis 71 oder eine Mischung dieser Elemente) ist.

21. Verfahren nach einem der Ansprüche 16 - 20 unter Verwendung einer Vorrichtung nach einem der Ansprüche 1 - 15.

22. Beschichtung, insbesondere aus zumindest einer anorganischen Verbindung mit mindestens zwei unterschiedlichen Kationenkomponenten, hergestellt mit einem Verfahren nach einem der Ansprüche 16 - 21.
